Europäisches Patentamt

European Patent Office

Office européen des brevets

(11) Publication number: **0 301 862**
A2

## (12) EUROPEAN PATENT APPLICATION

(21) Application number: **88306966.8**

(22) Date of filing: **28.07.88**

(51) Int. Cl.⁴: **H 01 L 29/80**
H 01 L 29/205, H 01 L 29/64,
H 01 L 21/28, H 01 L 21/306

(30) Priority: **31.07.87 JP 191635/87**

(43) Date of publication of application:
**01.02.89 Bulletin 89/05**

(84) Designated Contracting States: **DE FR GB NL**

(71) Applicant: **SONY CORPORATION**
**7-35 Kitashinagawa 6-Chome Shinagawa-ku**
**Tokyo 141 (JP)**

(72) Inventor: **Kamada, Mikio c/o Patents Division**
**Sony Corporation 6-7-35 Kitashinagawa**
**Shinagawa-ku Tokyo 141 (JP)**

(74) Representative: **Thomas, Christopher Hugo et al**
**D Young & Co 10 Staple Inn**
**London WC1V 7RD (GB)**

(54) High electron mobility transistors.

(57) A high electron mobility transistor (20) includes a first semiconductive layer (13) having a narrow band gap, a second semiconductive layer (14, 15) having a wide band gap and a secondary gas channel (21) formed in the first semiconductive layer (13) near its interface opposing the second semiconductive layer (14, 15). A third semiconductive layer (16) is formed on the second semiconductive layer (14, 15) to become a gate area, the third semiconductive layer (16) forming a pn junction between it and the second semiconductive layer (14, 15). The third semiconductive layer (16) has a conduction band the lower end of which is higher than a lower end of a conduction band of the second semiconductive layer (14, 15) to form a barrier to suppress a gate leakage current.

FIG.4C

## Description

### HIGH ELECTRON MOBILITY TRANSISTORS

This invention relates to high electron mobility transistors (HEMTs).

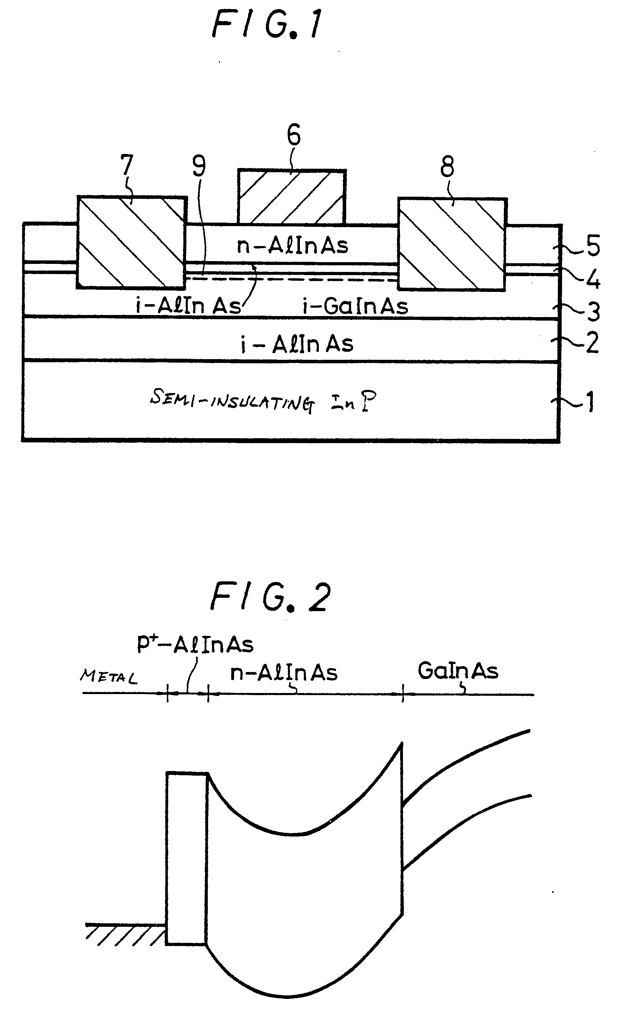

Figure 1 illustrates a previously proposed MES gate type HEMT of AlInAs/GaInAs system. On a semi-insulating InP substrate 1, there are epitaxially and sequentially grown an i-AlInAs layer 2, an i-GaInAs layer 3, an i-AlInAs layer 4 and an n-AlInAs layer 5. A metal gate electrode 6 is formed on the n-AlInAs layer 5, and metals are deposited and then alloyed on the n-AlInAs layer 5 at its portions corresponding to source and drain regions in ohmic contact to form a source electrode 7 and a drain electrode 8. A secondary electron gas channel 9 formed on the interface between the i-AlInAs layer 4 and the i-GaInAs layer 3 is represented by a dashed line.

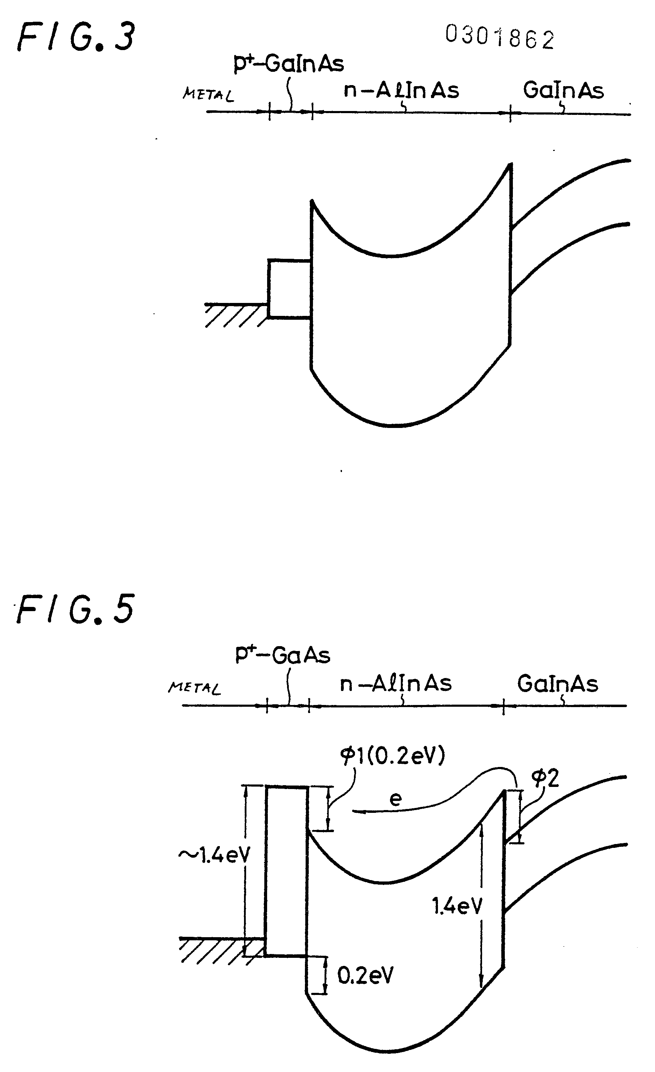

In this HEMT, the height of a Schottky barrier in the gate portion is comparatively low, so that when a gate voltage is applied in the forward direction, the electrons in the channel 9 flow towards the gate electrode 6, increasing a so-called gate leakage current. Thus, the operating voltage range of this HEMT becomes narrow. To remove this defect, a pn junction gate structure has been considered. In general, when the pn junction gate structure is formed in an AlInAs/GaInAs material system, it is natural that AlInAs or GaInAs is used as a p$^+$ layer. Figure 2 shows an energy band structure of a p$^+$-AlInAs layer, and Figure 3 shows an energy band structure of a p$^+$-GaInAs layer. Neither of them, however, can prevent the gate leakage current effectively.

Moreover, it is difficult selectively to remove only the p$^+$ layer that is formed of the AlInAs or GaInAs, thus making it difficult to manufacture the device.

According to the present invention there is provided a high electron mobility transistor comprising:
a first semiconductive layer of relatively narrow band gap; and
a second semiconductive layer of a relatively wide band gap;
wherein a secondary electron gas channel is formed in said first semiconductive layer and on its interface opposing said second semiconductive layer;
characterised by:
a third semiconductive layer formed on said second semiconductive layer to become a gate portion, said third semiconductive layer forming a pn junction between it and said second semiconductive layer and having a conduction band the lower end of which is higher than a lower end of a conduction band of said second semiconductive layer to form a barrier.

The invention will now be described by way of example with reference to the accompanying drawings, throughout which like parts are referred to by like references, and in which:

Figure 1 is a cross-sectional view illustrating an example of a previously proposed HEMT;

Figures 2 and 3 are energy band diagrams;

Figures 4A to 4C are cross-sectional views of an embodiment of HEMT according to the present invention, in the sequential order of manufacturing processes; and

Figure 5 is an energy band diagram of the embodiment.

An embodiment of HEMT according to the invention includes a first semiconductive layer having a narrow band gap and a second semiconductive layer having a wide band gap, wherein a secondary electron gas channel is formed in the first semiconductive layer and on the interface between it and the second semiconductive layer. A third semiconductive layer is formed on the second semiconductive layer to form a pn junction between it and the second semiconductive layer. The third semiconductive layer has a conduction band the low end of which is higher than the lower end of a conduction band of the second semiconductive layer in an energy band structure to form a barrier. This third semiconductive layer becomes a gate portion. The third semiconductive layer has a metal gate electrode formed thereon and also there are formed source and drain electrodes made of metal deposited thereon at positions corresponding to source and drain regions in ohmic contact.

Since the third semiconductive layer having the above-mentioned property is formed on the second semiconductive layer to form the pn junction structure, the HEMT can suppress a gate leakage current by the barrier upon applying a gate voltage thereto in the forward direction and it can, therefore, be operated in a wide operating voltage range.

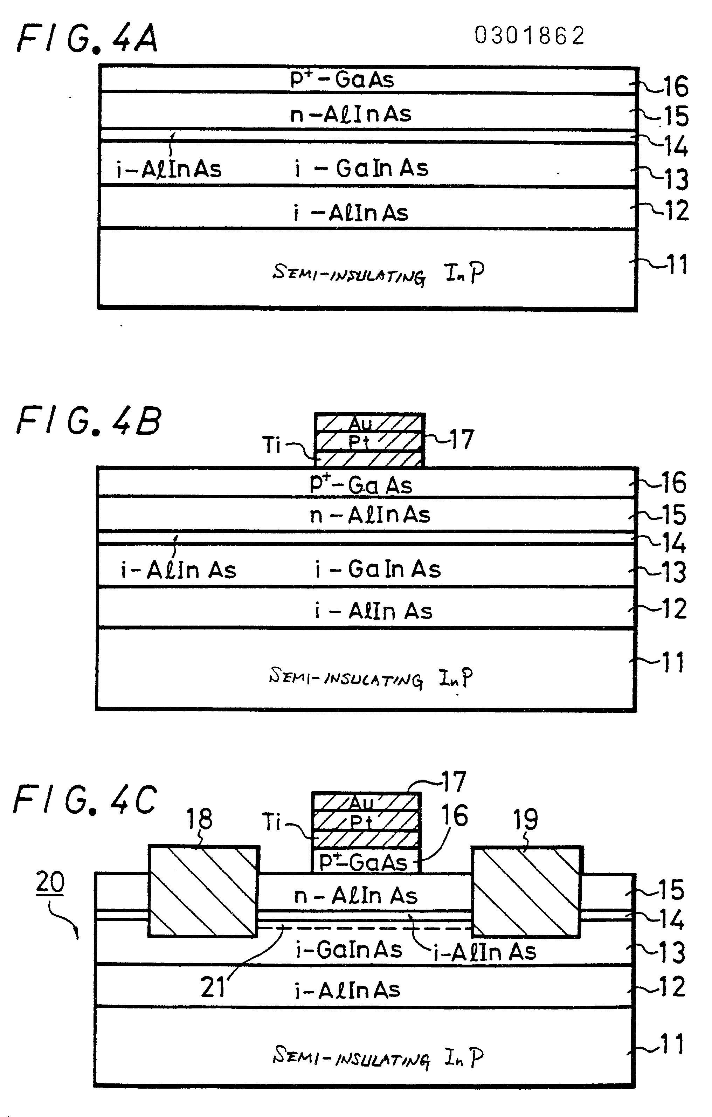

Now, a specific embodiment of HEMT and a manufacturing method thereof will be described with reference to Figures 4A to 4C.

Referring to Figure 4A, on a semi-insulating InP substrate 11, there are epitaxially grown an i-AlInAs layer 12 having a thickness of about 200 nm, a narrow band gap i-GaInAs layer 13 having a thickness of about 100 nm which becomes a channel forming layer, a wide band gap i-AlInAs layer 14 having a thickness of 5 nm, a wide band gap n-AlInAs layer 15 having a thickness of about 50 nm and having an impurity concentration of about 2 x $10^{18}$ cm$^{-3}$ and a p$^+$-GaAs layer 16 having a thickness of about 20 nm and having an impurity concentration of about 5 x 10 $^{18}$ cm$^{-3}$ which will become a gate portion.

Then, although not shown, it is subjected to the mesa-etching process separately to provide element forming regions. Thereafter, as shown in Figure 4B, Ti, Pt and Au are sequentially vapour-deposited on the p$^+$-GaAs layer 16 in ohmic contact, and undergo a patterning process to form a metal gate electrode 17.

Using the gate electrode 17 as a mask, the GaAs layer 16 is selectively removed by a reactive ion etching (RIE) process, thus causing the p$^+$GaAs layer 16 to be left only beneath the gate electrode 17. It is important that only the GaAs layer 16 is selectively removed according to the RIE process. The RIE process is performed with the following conditions. If, for example, a gas of $CCl_2F_2$ (16 cc/min) and He(4 cc/min) is used and the RIE process is performed at a power of 50 W and under a pressure of 2.67 pascal, the etching rate is at 350 nm/min for the GaAs and the etching rate is at 5 nm/min for the AlInAs and hence the selection ratio becomes 70. Thus, the GaAs layer 16 only can be selectively etched away.

Then, as shown in Figure 4C, on the n-AlInAs layer 15 at its regions where the source electrode and the drain electrode are to be formed, metal, for example, AuGe/Au, is respectively deposited in ohmic contact and then alloyed to form a source electrode 18 and a drain electrode 19, each of which reaches the i-GaInAs layer 13, producing a desired pn junction gate type HEMT 20. In Figure 4C, a secondary electron gas channel 21 is formed on the heterojunction interface.

Figure 5 is an energy band diagram of the thus made HEMT 20. Although the GaAs has substantially the same band gap as that of the AlInAs, the energy bands thereof are, however, not connected smoothly, causing a barrier ø1 of about 0.2 eV to occur in the conduction band. When a gate voltage is applied in the forward direction, this barrier ø1 can prevent the electrons e of the channel 21 from flowing into the gate electrode 17. Thus, in this embodiment, it is possible to obtain the HEMT 20 which can be operated in a wider operating voltage range.

While in this embodiment the lattice constant of the GaAs layer 16 is not coincident with the lattice constants of the GaInAs layer 13 and the AlInAs layers 12, 14 and 15 sequentially grown on the InP substrate 11, if the GaAs layer 16 is formed as a thin layer having a thickness of less than about 20 nm, that is, thickness of 10 nm to 20 nm, it is possible to form a monocrystalline layer of satisfactory quality.

Moreover, since the GaAs layer 16 can be selectively etched away by the RIE method from the AlInAs layer 15, the HEMT 20 can easily be manufactured.

In the case of the AlInAs/GaInAs system, as compared with the AlGaAs/GaAs system, the height of barrier ø2 on the heterojunction interface is twice or less, and the carrier density is twice. The mobility of electrons in the GaInAs layer is 1.5 times that in the GaAs layer, so that conductance of the GaInAs layer becomes 3 to 5 times as high as that of the GaAs layer.

While in the above embodiment the GaAs layer is used as the $p^+$ layer forming the gate portion, the GaAs layer may be replaced with the AlGaAs layer. The AlGaAs layer may prevent the gate leakage current more effectively than the GaAs layer does. The AlGaAs layer, however, has selective etching properties inferior to the GaAs layer.

Thus, with embodiments of the invention, when the gate voltage is applied in the forward direction, the gate leakage current can be suppressed, so that a HEMT having a wide operating voltage range, can be manufactured.

**Claims**

1. A high electron mobility transistor (20) comprising:
a first semiconductive layer (13) of relatively narrow band gap; and
a second semiconductive layer (14, 15) of a relatively wide band gap;
wherein a secondary electron gas channel (21) is formed in said first semiconductive layer (13) and on its interface opposing said second semiconductive layer (14, 15);
characterised by:
a third semiconductive layer (16) formed on said second semiconductive layer (14, 15) to become a gate portion, said third semiconductive layer (16) forming a pn junction between it and said second semiconductive layer (14, 15) and having a conduction band the lower end of which is higher than a lower end of a conduction band of said second semiconductive layer (14, 15) to form a barrier.

2. A transistor (20) according to claim 1 wherein said third semiconductive layer (16) is made of GaAs.

3. A transistor (20) according to claim 1 wherein said third semiconductive layer (16) is made of AlGaAs.

4. A transistor (20) according to claim 1, claim 2 or claim 3 wherein said barrier is about 0.2 eV.

0301862

# FIG.1

# FIG.2

# FIG.3

0301862

p⁺-GaInAs · METAL · n-AlInAs · GaInAs

# FIG.5

p⁺-GaAs · METAL · n-AlInAs · GaInAs

$\phi 1(0.2eV)$

e

$\phi 2$

~1.4eV

1.4eV

0.2eV

**FIG.4A**

| | |
|---|---|
| P⁺-GaAs | ~16 |
| n-AℓInAs | ~15 |
| | ~14 |
| i-AℓInAs     i-GaInAs | ~13 |
| i-AℓInAs | ~12 |
| SEMI-INSULATING InP | ~11 |

**FIG.4B**

Ti — Au / Pt ~17

| | |
|---|---|
| P⁺-GaAs | ~16 |
| n-AℓInAs | ~15 |
| | ~14 |
| i-AℓInAs     i-GaInAs | ~13 |
| i-AℓInAs | ~12 |
| SEMI-INSULATING InP | ~11 |

**FIG.4C**

17
18    Ti — Au / Pt   16    19

20

| | |
|---|---|
| P⁺-GaAs | |
| n-AℓInAs | ~15 |
| | ~14 |
| i-GaInAs   i-AℓInAs | ~13 |
| 21    i-AℓInAs | ~12 |
| SEMI-INSULATING InP | ~11 |